# EUROPÄISCHE PATENTSCHRIFT

(11) **EP 4 030 135 B1**
(45) Veröffentlichungstag und Bekanntmachung des Hinweises auf die Patenterteilung: **05.07.2023**
(21) Anmeldenummer: 22000004.6
(22) Anmeldetag: 04.01.2022
(51) Int. Cl.: G01B 7/00, G01D 3/036, G01D 3/08, G01R 27/26, G01R 31/28, G01V 3/10, H03K 17/95

(54) **INDUKTIVE SENSOREINHEIT**
INDUCTIVE SENSOR UNIT
UNITÉ DE CAPTEUR INDUCTIF

(30) Priorität: 15.01.2021 DE 102021000158
(43) Veröffentlichungstag der Anmeldung: 20.07.2022
(73) Patentinhaber: Pepperl+Fuchs SE, 68307 Mannheim (DE)
(72) Erfinder: Braunsmann, Christoph, 68307 Mannheim (DE)
(74) Vertreter: Koch Müller Patentanwaltsgesellschaft mbH

(56) Entgegenhaltungen:
- DE-A1-102015 216 651
- DE-A1-102017 128 471
- DE-A1-102017 128 472
- DE-A1-102017 130 122
- DE-A1-102018 103 239
- DE-B3-102009 052 467
- DE-B4-102009 046 691
- DE-U1-202011 001 009
- US-A1- 2010 225 332

## Beschreibung

Die Erfindung betrifft eine induktive Sensoreinheit zum Ermitteln eines Abstands zu einem metallischen Gegenstand.

Eine induktive Sensoreinheit in Form eines Näherungsschalters ist aus der DE 10 2017 128 472 A1 bekannt. Der Näherungsschalter weist einem Schwingkreis mit einer Sensorspule und einem Kondensator auf, wobei während des Betriebs ein Ist-Wert der Induktivität der Sensorspule des Schwingkreises gemessen, z.B. mittels eines Lock-In-Verstärkers, und die Sensoreinheit, also z.B. der Schwingkreis, der Oszillatorverstärker und/oder die Ausgangsstufe, in Abhängigkeit von der gemessenen Induktivität eingestellt wird. Hierdurch wird der Einfluss temperaturbedingter Induktivitätsänderungen der Sensorspule auf den Schaltabstand reduziert oder sogar vollständig kompensiert.

Eine weitere induktive Sensoreinheit mit Kompensation temperaturbedingter Induktivitätsänderungen ist aus der DE 10 2017 130 122 A1 bekannt. Die Sensoreinheit weist eine Sensorspule, aber keinen LC-Schwingkreis auf und arbeitet nach dem sogenannten Pulsauswerteverfahren. Die Sensorspule wird während eines Anregungszeitraums mit einem Strompuls angeregt und während eines sich anschließenden Sperrzeitraums von der Stromquelle getrennt. Um eine Änderung der Induktivität und / oder des Wirkwiderstands der Sensorspule zu ermitteln, wird der Strom oder die Spannung an der Sensorspule bereits während des Anregungszeitraums abgetastet. Ermittelte Änderungen werden zur Kompensation eines während des Sperrzeitraums abgetasteten Impulsantwortsignals zur Abstandsermittlung verwendet.

Aus der EP 0 049 304 A1, der EP 0 813 306 B1 und der DE 10 2013 202 573 B3 sind weitere gattungsgemäße Sensoreinheiten bekannt.

Aus der DE 20 2011 001 009 U1 wird anhand einer Messung der Spulengüte und eines Vergleichs mit einem Ist-Wert ein Diagnose- bzw. Warnsignal erzeugt und ausgegeben.

Aus der DE 10 2009 046 691 B4 ist ein Sensorgerät mit einem Diagnosegerät bekannt, wobei mittels des Sensorgerätes dem Diagnosegerät Diagnosesignale zur Auswertung bereitgestellt werden.

Aus der DE 10 145 669 A1 ist eine induktive Sensoreinheit mit einem zusätzlichen Temperaturfühler sowie einem entsprechenden Ausgangsanschluss für ein Temperatursignal bekannt.

Vor diesem Hintergrund besteht die Aufgabe der Erfindung darin, eine Vorrichtung anzugeben, die den Stand der Technik weiterbildet.

Die Aufgabe wird durch eine induktive Sensoreinheit mit den Merkmalen des Patentanspruchs 1 gelöst. Vorteilhafte Ausgestaltungen der Erfindung sind Gegenstand von Unteransprüchen.

Das Grundprinzip einer induktiven Sensoreinheit beruht auf einer Änderung der Induktivität bzw. der Güte der Sensorspule bei Annäherung eines metallischen Gegenstands.

Bei einem nicht zur Erfindung gehörenden Beispiel bildet die Sensorspule beispielsweise zusammen mit einem Kondensator einen Schwingkreis (LCR-Oszillator), wobei der Schwingkreis mittels eines Oszillatorverstärkers bei einer Resonanzfrequenz betrieben wird.

Alternativ wird die Sensorspule mittels eines Strompulses bzw. periodisch wiederkehrender Strompulse angeregt und nach dem sogenannten Pulsauswerteverfahren ausgewertet.

Das mittels des Strompulses oder der Schwingung des Schwingkreises von der Spule erzeugte Magnetfeld induziert ab einem ausreichend geringen Abstand eines sich nähernden metallischen Gegenstands Wirbelströme in dem Gegenstand.

Die induzierten Wirbelströme führen aufgrund der magnetischen Kopplung zwischen dem metallischen Gegenstand und dem Schwingkreis bzw. der Spule zu einer Änderung der Frequenz und / oder der Amplitude des Schwingkreises bzw. des von der Spule empfangenen Pulsantwortsignals. Anders ausgedrückt der Selbstinduktions-Spannungspuls der durch den einzelnen Spannungspuls angeregten Sensorspule wird verändert.

Anhand der Änderung lässt sich zumindest die Anwesenheit des metallischen Objekts und / oder die Art des metallischen Objekts und / oder der Abstand des metallischen Objekts und / oder das Erreichen eines Schaltabstands ermitteln.

Eine Änderung der Induktivität der Sensorspule und / oder des Wirkwiderstands der Spule, die zu einer Änderung der Schwingkreisamplitude und / oder -frequenz bzw. zu einer Änderung der Spulenspannung führt, wird auch durch andere Einflüsse verursacht, z.B. durch Temperaturänderungen, durch die Auswirkung mechanischer Belastungen wie insbesondere Kernbruch und Magnetostriktion, sowie Desakkommodation und externe Magnetfelder.

Ein Vorteil ist, dass sich auf Basis einer zusätzlichen vom Objektabstand weitestgehend unabhängigen Messung der Induktivität und / oder des Wirkwiderstands der Sensorspule durchführen lässt, um insbesondere die Verfälschung der Abstandsmessung durch die vorgenannt beschriebenen anderen Einflüsse besonders vorteilhaft zu korrigieren.

Zum anderen stellen die Induktivität oder der Wirkwiderstand der Sensorspule bzw. daraus abgeleitete Größen Messwerte dar, die für weitere über die eigentliche Aufgabe der Objekterfassung hinausgehende Auswertungen nützlich sind.

Erfindungsgemäß ist die Schaltungseinheit daher dazu ausgelegt, die Induktivität und / oder den Wirkwiderstand der Sensorspule zu überwachen, d.h. einmal oder mehrmals einen Istwert der Induktivität und / oder des Wirkwiderstands und / oder einer zu diesen Werten in einem funktionalen Zusammenhang stehenden abgeleiteten Größe zu ermitteln und diese mittels einer Schnittstelle bereitzustellen.

Es zeigte sich, dass sich die in einer Anlage verbaute induktive Sensoreinheit z.B. zusätzlich als Temperatursensor verwenden lässt. Gerade bei niedrigen Frequenzen ist der gemessene Wirkwiderstand der Spule proportional zur Spulentemperatur.

Ein weiterer Vorteil ist, dass insbesondere wenn mehrere erfindungsgemäße Sensoreinheiten in einer Anlage verbaut sind, ein Betreiber von Anlagen auf einfache Weise ein Temperaturprofil seiner Anlage erstellen kann, ohne dazu zusätzliche separate Temperatursensoren installieren zu müssen.

Hieraus ergeben sich erhebliche Kostenersparnisse, ein reduzierter Verkabelungsaufwand sowie ein reduzierter Platzbedarf, welcher gerade bei beengten Verhältnissen vorteilhaft ist.

Darüber hinaus liefern Änderungen der Induktivität der Sensorspule beispielsweise Hinweise auf mechanische Belastungen, hohe Temperaturen oder starke Magnetfelder im Bereich der induktiven Sensoreinheit.

Ein weiterer Vorteil ist, dass sich beispielsweise durch Computeralgorithmen die die Messwerte automatisiert analysiert und für eine Zustandsüberwachung der Anlage verwendet lassen.

Bei einem nicht zur Erfindung gehörendem Beispiel weist die Sensoreinheit beispielsweise eine modulierte Stromquelle zum Einprägen eines Teststroms in den Schwingkreis und einen Lock-In-Verstärker zum Zerlegen des Stromabfalls an einem Strommesswiderstand in einen Real- und Imaginärteil auf.

Alternativ wird der Strom bzw. die Spannung an den beiden Enden der durch Strompulse angeregten Sensorspule abgegriffen.

In einer Ausführungsform weisen die Schaltungseinheit und die Auswerteeinheit jeweils eine eigene Recheneinheit auf. Alternativ werden die Schaltungseinheit und die Auswerteeinheit zumindest in Teilen durch dieselbe Recheneinheit ausgebildet.

Der Wirkwiderstand der Sensorspule ändert sich beispielsweise sowohl aufgrund einer temperaturbedingten Änderung der Leitfähigkeit als auch aufgrund eines Litzendrahtbruchs, z.B. durch Alterung oder durch mechanische Beanspruchung. Die Induktivität ändert sich beispielsweise bei einem Bruch oder einer Magnetostriktion des Ferritkerns, z.B. aufgrund mechanischer Beanspruchung.

Die Schnittstelle dient entsprechend der weiteren Auswertung und / oder Überwachung, z.B. lässt sich das bereitgestellte Signal auswerten und gegebenenfalls mittels eines Warnsignals auf aktuelle Probleme hinweisen. Gemäß einer anderen Ausführungsform werden die via der Schnittstelle bereitgestellten Ist-Werte aufgezeichnet und beispielsweise zu Wartungszwecken herangezogen.

In einer Ausführungsform ist die Schnittstelle eingerichtet, den Istwert des Wirkwiderstands und / oder den Istwert der Induktivität und / oder die abgeleitete Größe analog und / oder digital bereitzustellen.

In einer anderen Ausführungsform ist die Schaltungseinheit dazu ausgelegt, an mehreren Zeitpunkten aus dem Verlauf der Spulenspannung Istwerte zu bestimmen. So kann der zeitliche Verlauf der Ist-Werte überwacht bzw. zu Auswertezwecken, insbesondere zur Störungsanalyse, herangezogen werden.

Erfindungsgemäß ist die Schaltungseinheit ausgelegt, den Wirkwiderstand und / oder die Induktivität und / oder die abgeleitete Größe aus dem zeitlichen Verlauf der Spulenspannung zu bestimmen.

In einer anderen Weiterbildung umfasst das Signal einzelne zeitlich voneinander beabstandete Pulse oder eine Schwingung.

Gemäß einer anderen Ausführungsform ist eine Pulsfrequenz zur Bestimmung des Wirkwiderstandes und / oder der Induktivität identisch mit der Pulsfrequenz zur Bestimmung des Objektabstandes.

Alternativ unterscheidet sich die Pulsfrequenz zur Bestimmung des Wirkwiderstands und der Induktivität von der Pulsfrequenz zur Bestimmung des Objektabstands.

Gemäß einer weiteren Weiterbildung weist die induktive Sensoreinheit einen zusätzlichen Sensor auf und die Schaltungseinheit ist dazu ausgelegt, ein Sensorsignal des zusätzlichen Sensors zu empfangen und das Sensorsignal oder ein weiterverarbeitetes Sensorsignal über die Schnittstelle auszugeben.

In einer anderen Ausführungsform umfasst der zusätzliche Sensor einen Temperatursensor und der Temperatursensor erfasst die Temperatur am Ort der Sensorspule.

Gemäß einer weiteren Ausführungsform ist die Sensorspule mit der Auswerteeinheit mittels eines Kabels verschaltet und das Kabel weist eine Länge zwischen mindestens 1 m und maximal 50 m auf. Alternativ beträgt die Länge zwischen 5 m und 20 m.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Ansicht auf ein nicht zur Erfindung gehörendes Beispiel,
- Figur 2: eine Ansicht auf eine Ausführungsform der Erfindung,
- Figur 3: einen beispielhaften Verlauf einer Schalt- und einer Sensorspulenspannung.

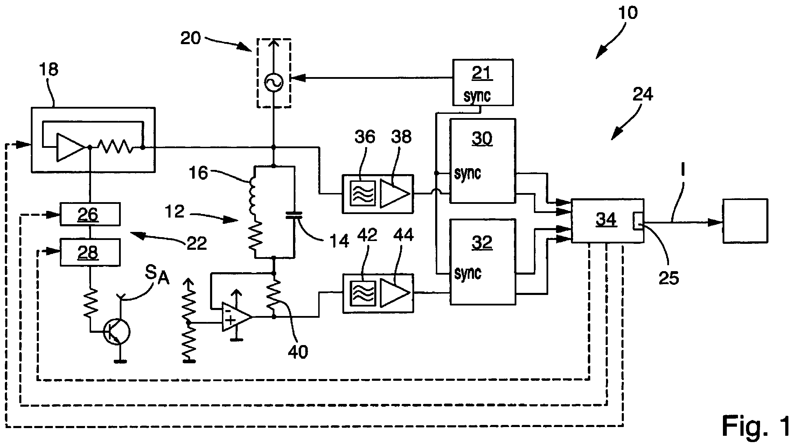

Die Abbildung der Figur 1 zeigt ein nicht zur Erfindung gehörendes Beispiel einer induktiven

Sensoreinheit 10 mit einem LC-Schwingkreis 12 zur Abstandsbestimmung eines metallischen Objekts. Die Sensoreinheit 10 weist den Schwingkreis 12, einen Oszillatorverstärker 18, eine einstellbare Stromquelle 20 mit einem Funktionsgenerator 21 zur Beaufschlagung der Sensoreinheit 10 mit einem Teststrom als Anregungssignal, einer Auswerteeinheit 22 und einer Schalteinrichtung 24 mit einer Schnittstelle 25.

Der Schwingkreis weist einen Kondensator 14, eine Sensorspule 16 mit einer Induktivität L und einen Wirkwiderstand Rₛ auf. Verluste des Schwingkreises werden durch den Oszillatorverstärker 18 ausgeglichen, so dass der Schwingkreis im Betrieb mit seiner Resonanzfrequenz schwingt.

Die Auswerteeinheit 22 weist in dem dargestellten Ausführungsbeispiel eine Gleichrichter 26 zur Amplitudenbestimmung und einen Komparator 28 auf, wobei der Komparator 28 ein Abstandssignal S_{A} über eine Transistorstufe bereitstellt.

Die Schalteinheit 24 weist einen ersten Lock-In-Verstärker 30, einen zweiten Lock-In-Verstärker 32 und eine Recheneinheit 34 auf, wobei der erste Lock-In-Verstärker 30 den vom Teststrom verursachten Spannungsabfall über den Wirkwiderstand Rₛ und der Induktivität L misst und der zweite Lock-In-Verstärker 32 den vom Teststrom verursachten Spannungsabfall über den Strommesswiderstand 40 misst.

Damit die Bestimmung der Induktivität L bzw. des Wirkwiderstands Rₛ unabhängig von dem metallischen Objekts bzw. dessen Bewegung ist, weist der Teststrom bevorzugt eine niedrige Frequenz, z.B. 100 Hz, insbesondere deutlich niedriger als die Resonanzfrequenz des Schwingkreises 12.

Die an dem Schwingkreis 12 anliegende Spannung wird über einen Bandpassfilter 36 zum Herausfiltern der Oszillatorschwingung und einen Verstärker 38 auf einen Eingang des ersten Lock-In-Verstärkers 30 gelegt und mittels des Lock-In-Verstärkers 30 in einen Realteil und einen Imaginärteil zerlegt.

Über einen Strommesswiderstand 40 wird der Teststrom gemessen. Hierfür ist der Strommesswiderstand 40 wiederum über einen Bandpassfilter 42 und einen Verstärker 44 mit einem Eingang des zweiten lock-In-Verstärkers 32 verbunden und die gemessene Spannung wird mittels des Lock-In-Verstärkers 32 in einen Realteil und einen Imaginärteil zerlegt.

Die Recheneinheit 34 ist dazu ausgelegt anhand der Real- und Imaginärteile der Lock-In-Verstärker 30 und 32 einen Istwert I der Induktivität L der Sensorspule 16 und / oder einen Istwert I des Wirkwiderstands Rₛ der Sensorspule 16 und/oder eine zu dem Istwert I der Induktivität L oder zu dem Istwert I des Wirkwiderstands Rₛ in einem funktionalen Zusammenhang stehende abgeleitete Größe zu ermitteln.

In einer optionalen Weiterbildung werden die ermittelten Istwerte zusätzlich zu Kompensationszwecken genutzt, also zum Ausgleich von beispielsweise temperaturbedingten Änderungen der Induktivität, soweit dies möglich ist. Beispielsweise ist die Recheneinheit 34 auch dazu ausgelegt aus den ermittelten Istwerten eine Kompensation abzuleiten und den Oszillatorverstärker 18 und / oder den Gleichrichter 26 und / oder den Komparator 28 gegebenenfalls entsprechend einzustellen bzw. zu regeln (gestrichelt dargestellt).

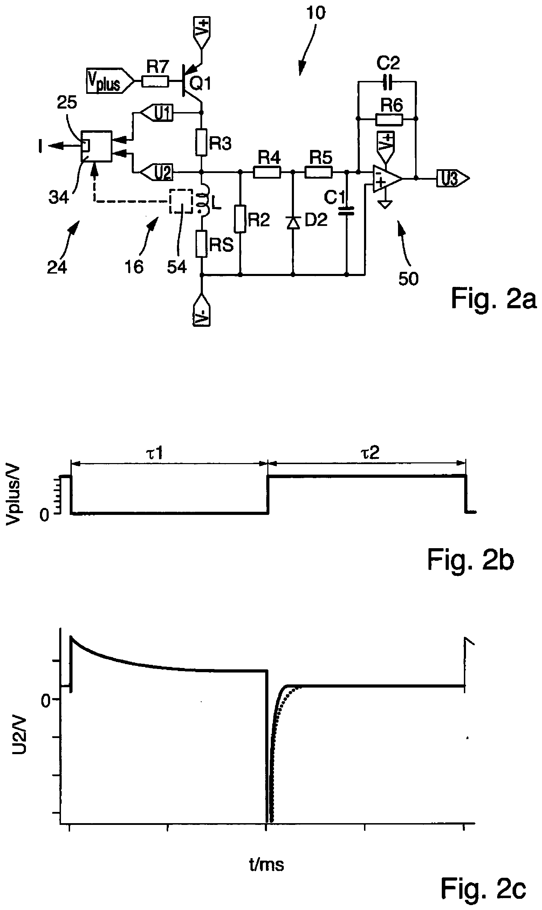

In der Abbildung der Figur 2 ist die erfindungsgemäße Sensoreinheit 10 dargestellt. Im Folgenden werden nur die Unterschiede zu der Abbildung der Figur 1 erläutert.

Erfindungsgemäß weist die Sensoreinheit 10 keinen LC-Schwingreis 12 auf. Die Sensorspule 16 mit der Impedanz L und dem Wirkwiderstand Rₛ wird über einen Transistors Q1 und einen Widerstand R3 für ein Zeitintervall T₁ mit einer Spannungsquelle V+ als Anregungssignal verbunden und für ein sich anschließendes Zeitintervall τ₂ mittels des Transistors Q1 wieder von der Spannungsquelle V+ getrennt. Das entsprechende Steuersignal V_{Puls} des Transistors Q1 ist in Abschnitt b der Figur 2 als Funktion der Zeit t dargestellt.

Nach dem Trennen der Sensorspule 16 von der Spannungsquelle V+ führt die Selbstinduktion der Sensorspule 16 zu einem Selbstinduktions-Spannungspuls. Befindet sich der metallische Gegenstand in der Nähe der Sensoreinheit 10, so erzeugen die in dem Gegenstand induzierten Wirbelströme eine den Selbstinduktions-Spannungspuls überlagernde Spannungspulsantwort in der Sensorspule 16. Der zeitliche Verlauf der Spannung U₂ an der Sensorspule 16 mit (gestrichelt) und ohne (durchgezogene Linie) Gegenstand ist in Abschnitt c der Figur 2 dargestellt.

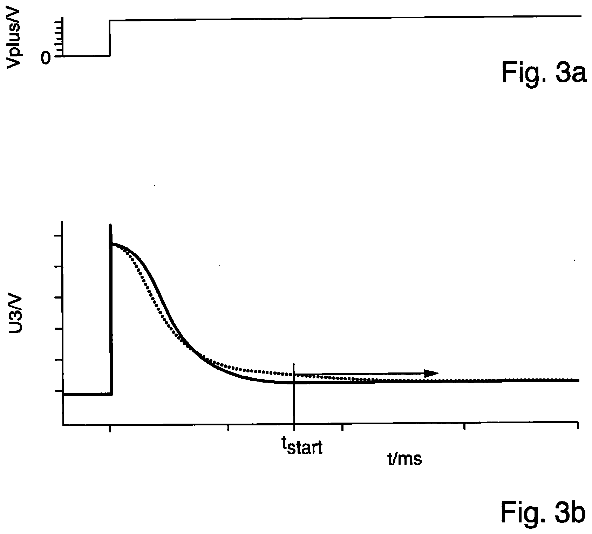

Die Sensoreinheit 10 weist außerdem einen Bedämpfungswiderstand R4, eine die Spulenspannung limitierende Diode D2 und eine Verstärkungsschaltung 50 auf. Eine nach der Verstärkungsschaltung 50 abgreifbare Spannung U₃ der Sensorspule 16 ist in der Abbildung der Figur 3 (unten) zusammen mit dem Steuersignal des Transistors Q1 (oben) dargestellt. Der Unterschied der Spannungsverläufe mit (gestrichelt) und ohne (durchgezogenen Linie) metallischen Gegenstand ist zu erkennen. Der Zeitpunkt tₛₜₐᵣₜ zeigt beispielhaft einen Anfangszeitpunkt für ein Abtasten des Verlaufs der Spannung U₃, um den Abstand des Objekts zu ermitteln.

Erfindungsgemäß weist die Schaltungseinheit 24 zum Bestimmen eines Istwerts der Induktivität der

Sensorspule die Recheneinheit 34 auf, wobei die Recheneinheit 34 zumindest Abtastwerte der Spannung U₂ der Sensorspule 16 und einer Spannung U₁ vor dem Widerstand R3 empfängt.

Optional weist die Sensoreinheit 10 einen zusätzlichen Sensor 54 (gestrichelt) auf. Beispielsweise ist als zusätzlicher Sensor 54 ein Temperatursensor thermisch mit der Sensorspule 16 gekoppelt, wobei die Recheneinheit 34 dazu ausgelegt ist, den Temperatursensor 54 auszulesen und die Ist-Temperatur oder eine von der Ist-Temperatur abgeleitete Größe mittels der Schnittstelle 25 bereitzustellen.

Damit die Bestimmung der Induktivität L bzw. des Wirkwiderstands Rₛ weitestgehend unabhängig von dem metallischen Objekts bzw. dessen Bewegung ist, ist die Schaltungseinheit 24 dazu ausgelegt, die Spannungen U₁ und U₂ in dem Zeitinterwall τ₁ abzutasten.

Wie aus dem Schaltbild im Abschnitt a der Figur 2 hervorgeht, gilt für den Strom durch die Sensorspule 16 I_{L} = I_{R3} - I_{Rτ}, wobei mit Rₜ ein sich aus der weiteren Schaltung, insbesondere R₄, ergebender effektiver Bedämpfungswiderstand bezeichnet wird. Für den Spannungsabfall über der Sensorspule 16 gilt U₂ - V₋ = L dI_{L}/dt + R_{S} I_{L}.

Am Ende des Zeitintervalls τ₁ zu einem Zeitpunkt t_{const} stellt sich ein im Wesentlich konstanter Strom durch die Sensorspule ein, so dass für den Wirkwiderstand R_{S} zum Zeitpunkt t_{const} näherungsweise gilt R_{S} = (U₂ - V.) / I_{L}. Mittels der Näherung kann somit der Istwert I des Wirkwiderstand R_{S} zum Zeitpunkt t_{const} und anschließend auch der Istwert I der Induktivität L bestimmt werden, z.B. mittels eines Fit des gemessenen Verlaufs der Spannung U₂ mit der Methode der kleinsten Quadrate.

Die Recheneinheit 34 ist außerdem dazu ausgelegt, die ermittelten Istwerte I oder eine aus einem oder mehreren Istwerten I abgeleitete Größe, z.B. durch Vergleich mit einem Sollwert, mittels der Schnittstelle 25 bereitzustellen.

## Patentansprüche

1. Induktive Sensoreinheit (10) zum Erfassen eines Abstands zu einem metallischen Gegenstand, aufweisend
- eine Sensorspule (16), wobei die Sensorspule (16) eine Induktivität (L) und einen Wirkwiderstand (RS) aufweist, und die Sensorspule (16) mit einem Anregungssignal beaufschlagbar ist,
- einen Transistor (Q1),
- einen Widerstand (R3),
- eine Auswerteeinheit (22) zum Ermitteln des Abstands, wobei die Auswerteeinheit (22) dazu eingerichtet ist, in Abhängigkeit der Ermittlung ein Auswertesignal bereitzustellen,
- eine Schaltungseinheit (24) zum Bestimmen eines Istwerts (I) der Induktivität (L) der Sensorspule (16) und / oder eines Istwerts (I) des Wirkwiderstands (R_{S}) der Sensorspule (16) und/oder eine zu dem Istwert (I) der Induktivität (L) oder zu dem Istwert (I) des Wirkwiderstands (R_{S}) in einem funktionalen Zusammenhang stehende aus einem oder mehreren der Istwerte (I) abgeleitete Größe, wobei
- die Sensorspule (16) über den Transistor (Q1) und den Widerstand (R3) mit einer Spannungsquelle (V+) verbindbar ist, die dazu eingerichtet ist, ein Anregungssignal bereitzustellen, wobei der Steuerelektrode des Transistors (Q1) ein Steuersignal (V_{Puls}) zuführbar ist,
- die Schaltungseinheit (24) eine Recheneinheit (34) aufweist, die dazu eingerichtet ist, Abtastwerte einer Spannung (U₂) der Sensorspule (16) und einer Spannung (U₁) von dem Widerstand (R3) zu empfangen,
- die Recheneinheit (34) ausgelegt ist, an mehreren Zeitpunkten Istwerte (I) des Wirkwiderstands (R_{S}) und / oder der Induktivität (L) und / oder der abgeleiteten Größe aus dem zeitlichen Verlauf der Spulenspannung zu bestimmen, und
- die Recheneinheit (34) eine Schnittstelle (25) aufweist, um mittels der Schnittstelle (25) zusätzlich zu dem Auswertesignal den Istwert (I) des Wirkwiderstandes und / oder den Istwert (I) der Induktivität (L) und / oder die abgeleitete Größe bereitzustellen.

2. Induktive Sensoreinheit (10) nach Anspruch 1, **dadurch gekennzeichnet, dass** die Schnittstelle (25) eingerichtet ist, den Istwert (I) des Wirkwiderstands (R_{S}) und / oder den Istwert (I) der Induktivität (L) und / oder die abgeleitete Größe analog und / oder digital bereitzustellen.

3. Induktive Sensoreinheit (10) nach einem der vorstehenden Ansprüche 1, **dadurch gekennzeichnet, dass** das ein der Steuerelektrode des Transistors (Q1) zuzuführende Steuersignal (V_{Puls}) derart bereitgestellt ist, dass das Anregungssignal einzelne zeitlich voneinander beabstandete Pulse oder eine Schwingung umfasst.

4. Induktive Sensoreinheit (10) nach einem der vorstehenden Ansprüche, **dadurch gekennzeichnet, dass** die induktive Sensoreinheit (10) einen zusätzlichen Sensor (54) aufweist und die Schaltungseinheit (24) dazu ausgelegt ist, ein Sensorsignal des zusätzlichen Sensors (54) zu empfangen und das Sensorsignal oder ein weiterverarbeitetes Sensorsignal über die Schnittstelle (25) auszugeben.

5. Induktive Sensoreinheit (10) nach Anspruch 4, **dadurch gekennzeichnet, dass** der zusätzliche Sensor (54) einen Temperatursensor umfasst und der Temperatursensor die Temperatur am Ort der Sensorspule (16) erfasst.

## Claims

1. inductive sensor unit (10) for detecting a spacing from a metallic object, comprising
- a sensor coil (16), wherein the sensor coil (16) has an inductance (L) and an active resistance (RS), and the sensor coil (16) can be acted on by an excitation signal,
- a transistor (O1),
- a resistance (R3),
- an evaluating unit (22) for determining the spacing, wherein the evaluating unit (22) is arranged for the purpose of providing an evaluation signal in dependence on the determination,
- a switching unit (24) for determining an actual value (I) of the inductance (L) of the sensor coil (16) and/or an actual value (I) of the active resistance (R_{S}) of the sensor coil (16) and/or a variable having a functional correlationship with the actual value (I) of the inductance (L) and/or with the actual value (I) of the active resistance (R_{S}) and derived from one or more of the actual values (I),
wherein
- the sensor coil (16) is connectible by way of the transistor (Q1) and the resistance (R3) with a voltage source (V+) arranged to provide an excitation signal,
wherein a control signal (V_{Puls}) can be fed to the control electrode of the transistor (Q1),
- the switching unit (24) comprises a computing unit (34) arranged to receive scanning values of a voltage (U₂) of the sensor coil (16) and a voltage (U₁) from the resistance (R3),
- the computing unit (34) is configured to determine actual values (I) of the active resistance (R_{S}) and/or the inductance (L) and/or the derived variable from the time plot of the coil voltage at a plurality of time intervals and
- the computing unit (34) comprises an interface (25) to provide by means of the interface (25) the actual value (I) of the active resistance and/or the active value (I) of the inductance (L) and/or the derived variable additionally to the evaluation signal.

2. inductive sensor unit (10) according to claim 1, **characterised in that** the interface (25) is arranged to provide the actual value (I) of the active resistance (R_{S}) and/or the actual value (I) of the inductance (L) and/or the derived variable in analog and/or digital form.

3. inductive sensor unit (10) according to any one of the preceding claims, **characterised in that** the control signal (V_{Puls}) to be fed to the control electrode of the transistor (Q1) is provided in such a way that the excitation signal comprises individual pulses spaced from one another in time or an oscillation.

4. inductive sensor unit (10) according to any one of the preceding claims, **characterised in that** the inductive sensor unit (10) comprises an additional sensor (54) and the switching unit (24) is configured to receive a sensor signal of the additional sensor (54) and to deliver the sensor signal or a further-processed sensor signal by way of the interface (25).

5. inductive sensor unit (10) according to claim 4, **characterised in that** the additional sensor (54) comprises a temperature sensor and the temperature sensor detects the temperature at the location of the sensor coil (16).

## Revendications

1. Unité de détection inductive (10) pour détecter une distance par rapport à un objet métallique, comprenant
- une bobine de détection (16), laquelle bobine de détection (16) présente une inductance (L) et une résistance active (RS), et laquelle bobine de détection (16) peut être sollicitée par un signal d'excitation,
- un transistor (Q1),
- une résistance (R3),
- une unité d'évaluation (22) pour déterminer la distance, laquelle unité d'évaluation (22) est configurée pour générer un signal d'évaluation en fonction de la détermination et
- une unité de circuit (24) pour déterminer une valeur réelle (I) de l'inductance (L) de la bobine de détection (16) et/ou une valeur réelle (I) de la résistance active (R_{S}) de la bobine de détection (16) et/ou une grandeur déduite d'une ou plusieurs des valeurs réelles (I) présentant un lien fonctionnel avec la valeur réelle (I) de l'inductance (L) ou avec la valeur réelle (I) de la résistance active (R_{S}),
dans laquelle
- la bobine de détection (16) peut être connectée par le transistor (Q1) et la résistance (R3) à une source de tension (V+) qui est configurée pour générer un signal d'excitation, un signal de commande (V_{Puls}) pouvant être envoyé à l'électrode de commande du transistor (Q1),
- l'unité de circuit (24) comporte une unité de calcul (34) qui est configurée pour recevoir une tension (U₂) de la bobine de détection (16) et une tension (U₁) de la résistance (R3),
- l'unité de calcul (34) est conçue pour déterminer à plusieurs moments des valeurs réelles (I) de la résistance active (R_{S}) et/ou de l'inductance (L) et/ou de la grandeur déduite de l'évolution temporelle de la tension de la bobine, et
- l'unité de calcul (34) comporte une interface (25) pour générer au moyen de cette interface (25), en plus du signal d'évaluation, la valeur réelle (I) de la résistance active et/ou la valeur réelle (I) de l'inductance (L) et/ou la grandeur déduite.

2. Unité de détection inductive (10) selon la revendication 1, **caractérisée en ce que** l'interface (25) est configurée pour générer la valeur réelle (I) de la résistance active (R_{S}) et/ou la valeur réelle (I) de l'inductance (L) et/ou la grandeur déduite de manière analogique et/ou numérique.

3. Unité de détection inductive (10) selon une des revendications précédentes, **caractérisée en ce que** le signal de commande (V_{Puls}) à l'électrode de commande du transistor (Ql) est généré de telle sorte que le signal d'excitation comprend des impulsions individuelles espacées entre elles dans le temps ou une vibration.

4. Unité de détection inductive (10) selon une des revendications précédentes, **caractérisée en ce que** cette unité de détection inductive (10) comporte un détecteur supplémentaire (54) et que l'unité de commutation (24) est configurée pour recevoir un signal de détecteur du détecteur supplémentaire (54) et pour émettre le signal de détecteur ou un signal de détecteur transformé via l'interface (25).

5. Unité de détection inductive (10) selon la revendication 4, **caractérisée en ce que** le détecteur supplémentaire (54) comprend un détecteur de température et que ce détecteur de température détecte la température à l'endroit de la bobine de détection (16).
